**Europäisches Patentamt**

**European Patent Office**

**Office européen des brevets**

(11) Veröffentlichungsnummer: **0 208 087**
**B1**

(12) **EUROPÄISCHE PATENTSCHRIFT**

(45) Veröffentlichungstag der Patentschrift: **27.06.90**

(51) Int. Cl.⁵: **H 05 K 3/10, H 01 B 1/12**

(21) Anmeldenummer: **86106454.1**

(22) Anmeldetag: **13.05.86**

(54) **Kunststoffteil mit elektrischen Stromwegen.**

(30) Priorität: **25.05.85 DE 3518975**

(43) Veröffentlichungstag der Anmeldung:
**14.01.87 Patentblatt 87/03**

(45) Bekanntmachung des Hinweises auf die
Patenterteilung:
**27.06.90 Patentblatt 90/26**

(84) Benannte Vertragsstaaten:
**DE FR GB IT NL**

(56) Entgegenhaltungen:
EP-A-0 037 988
FR-A-2 402 379
GB-A-1 565 207
GB-A-2 033 667
US-A-3 561 110

IBM TECHNICAL DISCLOSURE BULLETIN, Band
27, Nr. 5, Oktober 1984, Seiten 2937-2938, New
York, US; E.W. MACE: "Subsurface circuitry on
polymeric substrates"

(73) Patentinhaber: BAYER AG
D-5090 Leverkusen 1 Bayerwerk (DE)

(72) Erfinder: Fahner, Karsten, Dipl.-Ing.
Schnarrenbergstrasse 24
D-7057 Winnenden 3 (DE)
Erfinder: Depcik, Hans Werner, Dipl.-Ing.
Vennstrasse 124 A
D-4000 Düsseldorf 22 (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Kunststoffteil gemäß dem Oberbegriff des Patentanspruches 1.

Ein solches Kunststoffteil ist aus der EP—A—0037988 bekannt.

Bekannt sind Leiterplatten aus Pertinax, bei denen von einer Seite elektronische Bauelemente mit ihren Drahtenden durch Bohrungen gestreckt werden, die auf der anderen Seite mit einem Leitungssystem aus dünnen metallischen Auflagen mindestens teilweise untereinander verbunden sind. Der Kontakt zwischen Drahtende und Leitungssystem wird durch Löten beim Überfahren eines heißen Lötbades bzw. nach dem Dampfphasenlöt-Verfahren hergestellt.

Der Nachteil dieser Leiterplatten besteht darin, daß die Herstellung von galvanisch aufgetragenen Leiterbahnen, das Bohren der Aufnahmen für die Bauelemente und das anschließende Verlöten sehr teuer ist.

Weiter können Fehler durch Kaltlötungen und Beschädigugnen der elektronischen Bauelemente infolge Hitzeeinwirkungen entstehen, die sich teilweise erst im späteren Betrieb bemerkbar machen. Auch Risse innerhalb der Platte sind möglich, die zu hohen, unerwünschten Übergangswiderständen führen.

Aus der GB—A—1565207 ist ein Kunststoffbauteil bekannt, bei dem elastisches leitendes Material für Stromwege dient mit dem elektrische Bauelemente mittels elastischem leitenden Elastomer verbunden werden.

Der Erfindung liegt die Aufgabe zugrunde, ein wirtschaftlich herstellbares Kunststoffteil mit Stromwegen zu finden, welches über betriebssichere Kontakte mit anderen elektrischen Bauelementen ohne Verwendung von Wärme und Werkzeugen bestückt werden kann, wobei die Stromwege gegebenenfalls nur indirekt zugänglich sein sollten.

Die Aufgabe wird gemäß dem kennzeichnenden beil des Anspruches 1 erfindungsgemäß gelöst.

Das Formteil, welches als Platte oder als räumlicher Körper ausgebildet sein kann, dient als Träger und Isolator für das elektrische System aus leitendem Kunststoff. Dieses System besteht aus Stromwegen, die vornehmlich in den parallel zur Oberfläche verlaufenden Ausnehmungen auf einer oder beiden Seiten liegen, und gegebenefalls Verstärkungen, die vornehmlich in den quer zur Oberfläche sich erstreckenden Durchbrüchen und Vertiefungen angeordnet sind.

Die Bestückung mit Bauelementen kann einseitig oder beidseitig erfolgen, wobei ein transparenter Kunststoff eine Kontrolle wesentlich erleichtert.

Die Bauelemente können mit ihren Kontaktstiften direkt in die Verstärkungen des leitenden Kunststoffes eingedrückt werden, wodurch eine sichere Halterung der Bauelemente sowie ein einwandfreier elektrischer Kontakt auch über eine lange Lebensdauer zu erreichen ist. Die Gefahr der Korrosion durch Luftzutritt oder durch Risse ist durch Verwendung von elastischem Kunststoff, insbesondere für das leitende System gering.

In einer besonderen Ausführungsform ist die Leitfähigkeit des leitenden Kunststoffes größer als 0,01 S/cm.

Alle leitfähigen Kunststoffe mit einer Leitfähigkeit von 0,25—0,02 S/cm sind besonders geeignet, da dann die erforderlichen Ströme mit praxisnahen Abmessungen ohne wesentliche Spannungsverluste weitergeleitet werden können.

Als leitende Kunststoffe sind beispielsweise geeignet: Liquid Siliconrubber (LSR) 10 Ω cm.

Polyacetylen (PAC)

| | |
|---|---|
| Eisen(III)chlorid in $CH_3CN$ | 19,23 Ω cm |
| Titan(IV)chlorid in $CH_2Cl_2$ | 3,95 Ω cm |
| Zinn(IV)chlorid in $CH_2Cl_2$ | 3,7 Ω cm |

Polyethylen/Ethylen-Vinylacetat-Kautschuk

| | |
|---|---|
| (PE/EVM) | 35 Ω cm |
| Polypropylen-Ruß | 100 Ω cm |
| Polycarbonatfolie | 1 Ω cm |

In einer anderen Ausführungsform besteht mindestens einer der Kunststoffe aus gespritztem Thermoplast.

Bei Massenartikeln ist es besonders wirtschaftlich, einen oder beide Kunststoffe zu spritzen, um preiswerte Produkte zu erhalten.

In einer weiteren Ausführungsform besitzen die meist langgestreckten Ausnehmungen eine Tiefe von 0,2—4 mm, insbesondere 0,8—2 mm.

Einerseits ist, um hohe Spannungsverluste zu vermeiden, ein bestimmter Querschnitt nötig; andererseits sollte die Platine nicht zu dick werden. Deshalf hat sich als besonders vorteilhaft eine Tiefe der Ausnehmungen von 0,8—2 mm herausgestellt, wobei im allgemeinen eine Breite von 0,5—4 mm ausreichend ist. Der leitende Kunststoff kann die Ausnehmungen ganz oder teilweise ausfüllen. Auch sind Stromwege denkbar, bei denen der leitende Kunststoff vorsteht, um einen größeren Leitungsquerschnitt zu erhalten.

In einer möglichen Ausführungsform sind als Durchbrüche Bohrungen vorgesehen, die nur teilweise mit leitendem Kunststoff ausgefüllt sind.

Durch die geometrische Kontur des Teiles des Durchbruches welcher nicht mit leitenden Kunststoff ausgefüllt ist, kann die Einführung der Kontaktstifte erleichtert werden und gegebenenfalls eine verbesserte Halterung gegen Auszug beispielsweise infolge Widerhakeneffekt erzielt werden.

In einer Ausführungsform ist mindestens der leitende Kunststoff durch eine isoliertende Schutzschicht abgedeckt.

Durch Aufspritzen einer dritten Schicht kann ein gegen Korrosion und Kurzschluß geschütztes Kunststoffteil hergestellt werden, wobei die äußeren Kontaktstifte durch die isolierende Schutzschicht gedrückt werden können. Solche Kunststoffteile sind beispielsweise bei Leuchten von Fahrzeugen, die mit Feuchtigkeit in Berührung kommen, besonders vorteilhaft. Durch weitere leitende Schichten kann auch eine Abschirmung erzeugt werden.

Auch ist es denkbar eine gewünschte Anzahl von Leiterplatten unmittelbar übereinander anzuordnen, und diese nur dort beispielsweise durch Kontaktstifte zu verbinden, wo der Schaltplan dieses vorschreibt. Auf diese Weise läßt sich ein kompaktes, umfangreiches Leitungssystem aufbauen.

Durch den leitfähigen Kunststoff ist es bei Massenprodukten möglich, in einem Arbeitsvorgang beispielsweise eine Leiterplatte nur durch Auftrag auf die Oberfläche des isolierenden Kunststoffes herzustellen, wobei die Kontakte elektrisch leitend eingedrückt werden können.

Der leitende Kunststoff wird als Stromweg mindestens teilweise in Ausnehmungen bzw. Durchbrüche eines durch Spritzgießen hergestellten Formteils aus isolierenden Kunststoff eingespritzt.

Das Verfahren ist sehr wirtschaftlich, da mehrere Komponenten, die von verschiedenen Spritzgießmaschinen kommen, nacheinander nach jeweiligen Umlegen in das nächste Werkzeug zu einem einheitlichen Formteil gespritzt werden können. So kann ein kompliziertes Kunststoffteil mit elektrischen Stromwegen und erforderlichenfalls abschirmenden Schichten gegen Wasser bzw. Streufeld in einem Arbeitsvorgang erzeugt werden.

Beispiele der Erfindung sind in den Zeichnungen dargestellt und werden im folgenden näher beschrieben. Es zeigen

Fig. 1 Querschnitt durch gestapelte Leiterplatten

Fig. 2 Draufsicht auf eine Leiterplatte

Fig. 3 Längsschnitt durch Leiterplatte

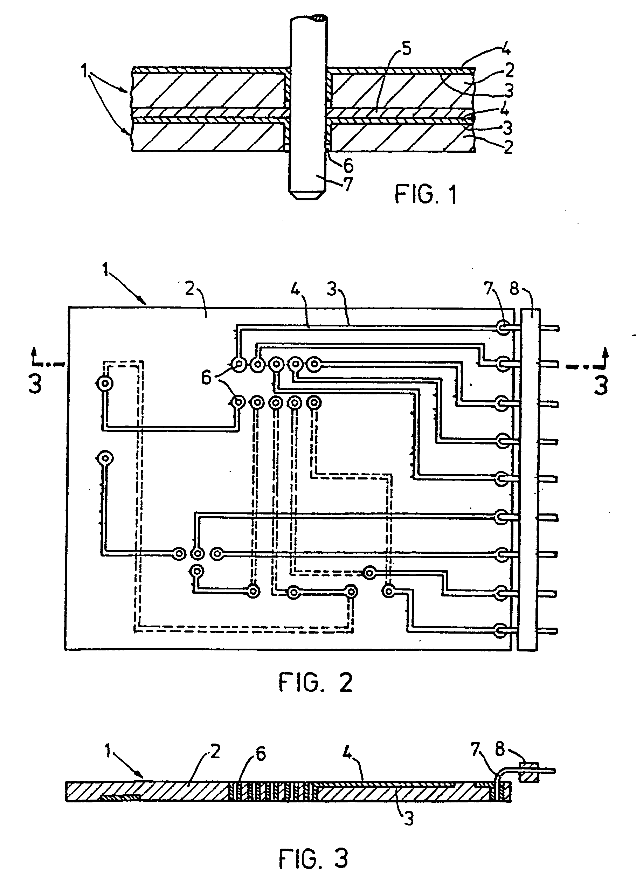

In Fig. 1 ist ein Querschnitt durch mehrere Leiterplatten 1 aus Kunststoff gezeigt bei dem ein Formteil 2 aus isolierenden Kunststoff mit Ausnehmungen 3 versehen ist, in die einleitender Kunststoff als Stromweg 4 eingespritzt ist. Hierauf wurde eine Schicht 5 aus isolierenden Kunststoff gespritzt, die ein weiteres Formteil 2 mit Stromweg 4 trägt. Durch eine durchgehende Bohrung als Durchbruch 6 ist ein Kontaktstift gestreckt.

In Fig. 2 und 3 ist eine Leiterplatte 1 dargestellt, bei der ein Formteil 2 unterhalb und oberhalb mit Ausnehmungen 3 versehen ist, die die Stromwege 4 aus leitenden Kunststoff aufnehmen. Weiter sind viele Durchbrüche 6 vorhanden, von denen einige durch kontaktiert sind, d.h. die Stromwege 4 auf der unteren Seite sind mit den Stromwegen 4 auf der oberen Seite verbunden. Am rechten Rand des Formteils sind in den Durchbrüchen 6 Kontaktstifte 7 einer Steckerleiste 8 angeordnet.

Das Formteil ist aus Polycarbonat (Makrolon® Typ 2800) gespritzt und besitzt eine Wandstärke von 2 mm. Als leitfähiger Kunststoff für die Stromwege 4 wurde liquid-silicon-rubber (LSR 3177/156) mit einem $R_o = 10\ \Omega \cdot cm$ und einer Wandstärke von 8,0 mm gespritzt.

## Patentansprüche

1. Kunststoffbauteil mit elektrischen Stromwegen, insbesondere Leiterplatten (1), bestehend aus einem Spritzgießformteil (2) aus isolierendem Kunststoff mit Ausnehmungen (3) und/oder Durchbrüchen (6), welche eine mindestens teilweise, die Stromwege bildende Füllung (4) aus leitfähigem Kunststoff aufweisen, dadurch gekennzeichnet, daß die Füllung (4) aus einem elastischen, thermoplastischen Spritzgießkunststoff besteht so daß die Verbindungen von Kontaktstiften (7) von elektrischen Bauelementen (8) mit der Füllung (4) allein durch Einstecken in diese Füllung (4) bestehen.

2. Kunststoffteil nach Anspruch 1, dadurch gekennzeichnet, daß die Füllung (4) aus liquid-silicon-rubber oder Polyethylen/Ethylen-Vinylacetate-Kautschuk besteht.

3. Kunststoffteil nach Anspruch 1 oder 2, dadurch gekennzeichnet, daß die Leitfähigkeit des leitenden Kunststoffes größer als 0,01 S/cm ist.

4. Kunststoffteil nach einem der Ansprüche 1 bis 3, dadurch gekennzeichnet, daß die Bauelemente (8) in nur eine teilweise Füllung (4) aufweisenden Ausnehmungen (3) und/oder Durchbrüchen (6) in dem von der Füllung (4) freien Bereich zusätzlich durch geometrische Konturierung verankert sind.

5. Kunststoffteil nach einem der Ansprüche 1 bis 4, dadurch gekennzeichnet, daß die Ausnehmungen (3) eine Tiefe von 0,2 bis 4 mm, insbesondere von 0,8 bis 2 mm, besitzen.

6. Kunststoffteil nach einem der Ansprüche 1 bis 5, dadurch gekennzeichnet, daß zumindest die Füllung (4) durch eine Schutzschicht (5) abgedeckt ist.

# EP 0 208 087 B1

**Revendications**

1. Elément en matière plastique comportant des trajets de courant électrique, notamment des plaquettes (1) de circuits imprimés, constitué d'une pièce (2) moulée par injection en matière plastique isolante présentant des évidements (3) et/ou des traversées (6), qui renferment au moins partiellement une charge (4) en matière plastique conductrice formant les trajets de courant, caractérisé en ce que la charge (4) est réalisée en une matière thermoplastique élastique moulable par injection, de telle sorte que les connexions de fiches de contact (7) de composants électriques (8) avec la charge (4) soient établies simplement par enfoncement dans cette charge (4).

2. Elément en matière plastique suivant la revendication 1, caractérisé en ce que la charge (4) est en caoutchouc de silicone liquide ou en caoutchouc de polyéthylène/éthylène-acétate de vinyle.

3. Elément en matière plastique suivant la revendication 1 ou 2, caractérisé en ce que la conductivité de la matière plastique conductrice est supérieure à 0,01 S/cm.

4. Elément en matière plastique suivant l'une des revendications 1 à 3, caractérisé en ce que les composants (8) insérés dans des évidements (3) et/ou des traversées (6) ne présentant qu'une charge partielle (4) sont ancrés en outre par leur conformation géométrique dans la zone dépourvue de charge (4).

5. Elément en matière plastique suivant l'une des revendications 1 à 4, caractérisé en ce que les évidements (3) ont une profondeur de 0,2 à 4 mm, notamment de 0,8 à 2 mm.

6. Elément en matière plastique suivant l'une des revendications 1 à 5, caractérisé en ce que la charge (4) est tout au moins recouverte d'une couche protectrice (5).

**Claims**

1. A plastics component comprising electrical paths, more especially circuit boards (1), consisting of an injection-moulded part (2) of an insulating plastic with recesses (3) and/or openings (6) which have an at least partial filling (4) of a conductive plastic forming the current paths, characterized in that the filling (4) consists of an elastic injection-moulding thermoplastic so that the connections of contact pins (7) of electrical components (8) with the filling (4) are established solely by insertion into the filling (4).

2. A plastics component as claimed in claim 1, characterized in that the filling (4) consists of liquid silicone rubber or polyethylene/ethylene—vinyl acetate rubber.

3. A plastics component as claimed in claim 1 or 2, characterized in that the conductivity of the conductive plastic is greater than 0.01 S/cm.

4. A plastics component as claimed in any of claims 1 to 3, characterized in that the components (8) are additionally anchored by geometric contouring in recesses (3) and/or openings (6) comprising only a partial filling (4) in the region free from the filling (4).

5. A plastics component as claimed in any of claims 1 to 4, characterized in that the recesses (3) have a depth of 0.2 to 4 mm and, more especially, 0.8 to 2 mm.

6. A plastics component as claimed in any of claims 1 to 5, characterized in that at least the filling (4) is covered by a protective layer (5).

4

FIG. 1

FIG. 2

FIG. 3